# EUROPEAN PATENT APPLICATION

(11) **EP 1 746 670 A2**
(43) Date of publication of application: **24.01.2007**
(21) Application number: 06117507.1
(22) Date of filing: 19.07.2006
(51) Int. Cl.: H01L 51/52

(54) **Electroluminescent device and electroluminescent device unit**

(30) Priority: 20.07.2005 JP 2005209514
(71) Applicant: KABUSHIKI KAISHA TOYOTA JIDOSHOKKI, Kariya-shi, Aichi 448-8671 (JP)
(72) Inventor: Harada, Masayuki, c/o KK Toyota Jidoshokki, Kariya-shi Aichi 448-8671 (JP); Kawauchi, Hiroyasu, c/o KK Toyota Jidoshokki, Kariya-shi Aichi 448-8671 (JP)
(74) Representative: TBK-Patent

(57) **Abstract**

An electroluminescent device has an electroluminescent layer, a first electrode, a second electrode, a first terminal and a second terminal. The electroluminescent layer is substantially rectangular and has two long sides and two short sides in plan view. The first electrode is connected to a first surface of the electroluminescent layer. The second electrode connected to a second surface of the electroluminescent layer. The second surface is opposite the first surface. The first terminal is connected to the first electrode. The second terminal is connected to the second electrode. The first terminal is formed along one long side of the electroluminescent layer. The second terminal is formed along one long side or the other long side of the electroluminescent layer.

## Description

### BACKGROUND OF THE INVENTION

The present invention relates to an electroluminescent (EL) device and more particularly to an EL device having a substantially rectangular electroluminescent (EL) layer and to an EL device unit including the EL device.

A known EL device generally includes an EL layer, an anode and a cathode. The anode is connected to one surface of the EL layer, and the cathode is connected to the other surface of the EL layer. The anode has an anode terminal, which is connected to an external conductor (anode conductor). The anode conductor is further connected to a positive electrode of an external power source. Thus, the positive electrode of the external power source is electrically connected to the anode of the EL device. On the other hand, the cathode has a cathode terminal, which is connected to an external conductor (cathode conductor). The cathode conductor is further connected to a negative electrode of the external power source. Thus, the negative electrode of the external power source is electrically connected to the cathode of the EL device. As the electrodes are energized through the anode and cathode conductors, the EL layer emits light. The EL device will have a luminescent face of desired shape by changing the shape of the EL layer. In recent years EL devices having a rectangular EL layer in plan view have been employed in many fields, which is disclosed in Japanese patent application publication No. 2001-244069. In the EL device disclosed in the above publication, the elongated anode terminal and the elongated cathode terminal are aligned along the same short side of the rectangular EL layer.

The above prior art takes advantage of this arrangement to cause electric current to stably flow to an electrode near one short side of the EL layer. This is disadvantageous in that a small amount of electric current flows through an electrode near the other side of the EL layer because of the long distance from the terminals. Thus, the EL layer emits light more brightly near one short side where a large amount of electric current flows than near the other short side where a small amount of electric current flows. Specifically, as the long side of the EL layer becomes longer, a difference in brightness, that is, uneven brightness, gets more remarkable in the long side direction of the EL layer.

The present invention is directed to reducing uneven brightness in an EL layer, as compared to a prior art.

### SUMMARY OF THE INVENTION

In accordance with the present invention, an electroluminescent device has an electroluminescent layer, a first electrode, a second electrode, a first terminal and a second terminal. The electroluminescent layer is substantially rectangular and has two long sides and two short sides in plan view. The first electrode is connected to a first surface of the electroluminescent layer. The second electrode connected to a second surface of the electroluminescent layer. The second surface is opposite the first surface. The first terminal is connected to the first electrode. The second terminal is connected to the second electrode. The first terminal is formed along one long side of the electroluminescent layer. The second terminal is formed along one long side or the other long side of the electroluminescent layer.

In accordance with the present invention, an electroluminescent device unit has an electroluminescent device and a conductor substrate. The electroluminescent device includes a laterally long electroluminescent layer in plan view, a first electrode connected to a first surface of the electroluminescent layer, a second electrode connected to a second surface of the electroluminescent layer and an electroluminescent device substrate. The second surface is opposite the first surface. The conductor substrate includes a first conductor electrically connected to the first electrode of the electroluminescent device and a second conductor electrically connected to the second electrode of the electroluminescent device. A breadth of the electroluminescent device substrate is larger than that of the conductor substrate.

Other aspects and advantages of the invention will become apparent from the following description, taken in conjunction with the accompanying drawings, illustrating by way of example the principles of the invention.

### BRIEF DESCRIPTION OF THE DRAWINGS

The features of the present invention that are believed to be novel are set forth with particularity in the appended claims. The invention together with objects and advantages thereof, may best be understood by reference to the following description of the presently preferred embodiments together with the accompanying drawings in which:
FIG. 1 is a plan view of an EL device unit according to a first preferred embodiment of the present invention;
FIG. 2 is a sectional view taken along the line II-II in FIG. 1;
FIG. 3 is a sectional view taken along the line III-III in FIG. 1;
FIG. 4 is a sectional view taken along the line IV-IV in FIG. 1;
FIG. 5 is a plan view of an EL device according to a second preferred embodiment of the present invention;
FIG. 6 is a plan view of an EL device according to a third preferred embodiment of the present invention;
FIG. 7 is a plan view of an EL device according to a fourth preferred embodiment of the present invention;
FIG. 8 is a plan view of an EL device according to a fifth preferred embodiment of he present invention;
FIG. 9A is a plan view of an EL layer having a rectangular shape according to an alternative embodiment of the present invention;
FIG. 9B is a plan view of an EL layer having a substantially rectangular shape according to an alternative embodiment of the present invention;
FIG. 9C is a plan view of an EL layer having an elliptical shape according to an alternative embodiment of the present invention; and
FIG. 10 is a plan view of an EL device according to an alternative embodiment of the present invention.

### DETAILED DESCRIPTION OF THE PREFERRED EMBODIMENTS

Preferred embodiments have the following main technical features.
(Feature 1) An EL device has a transparent glass substrate.
(Feature 2) An anode (first electrode) is made of transparent ITO (indium tin oxide, which is indium oxide doped with tin).
(Feature 3) An anode extends almost over the entire breadth of an EL device substrate (the long side length of an EL layer).
(Feature 4) An EL layer has a larger breadth than an anode.
(Feature 5) A cathode (second electrode) extends almost over the entire breadth of an EL layer.
(Feature 6) A cathode is made of a metal layer connected to an EL layer. A cathode terminal (second terminal) is made of a material having a higher volume resistivity than the metal forming the cathode and connected to the cathode.
(Feature 7) An anode is formed on the upper surface of a glass substrate (EL device substrate). The cathode terminal of Feature 6 is also formed on the glass substrate and made of the same material as the anode.
(Feature 8) The material of an anode has a higher volume resistivity than the material of a cathode. In this case, an anode terminal has a twice or more larger breadth than a cathode terminal. More preferably, the anode terminal has a ten times or more breadth than the cathode terminal.
(Feature 9) A flexible printed circuit (FPC) is used as a conductor substrate to connect an EL device to an external power source.
(Feature 10) When an anode terminal and a cathode terminal are aligned along one long side of an EL layer, a gap is formed between the anode terminal and the cathode terminal. This gap has a smaller breadth than the anode terminal and the cathode terminal.
(Feature 11) An auxiliary electrode extends in the long side direction of an EL layer.

Note that an electrode formed separately from a terminal or formed integrally with a terminal is regarded that "an electrode is connected to a terminal" in the preferred embodiments. The term "long side direction" and the term "short side direction" mean "long side direction of an EL layer" and "short side direction of an EL layer", respectively unless otherwise stated. The wording "terminals (a first terminal and a second terminal) are aligned along the long side of an EL layer" not only includes that the terminals extend continuously without any gap in between but also includes that the terminals are aligned discontinuously along the long side of an EL layer with a gap in between. "An area of a first electrode to which an EL layer is connected" is an area where a first electrode and an EL layer are overlapped in plan view.

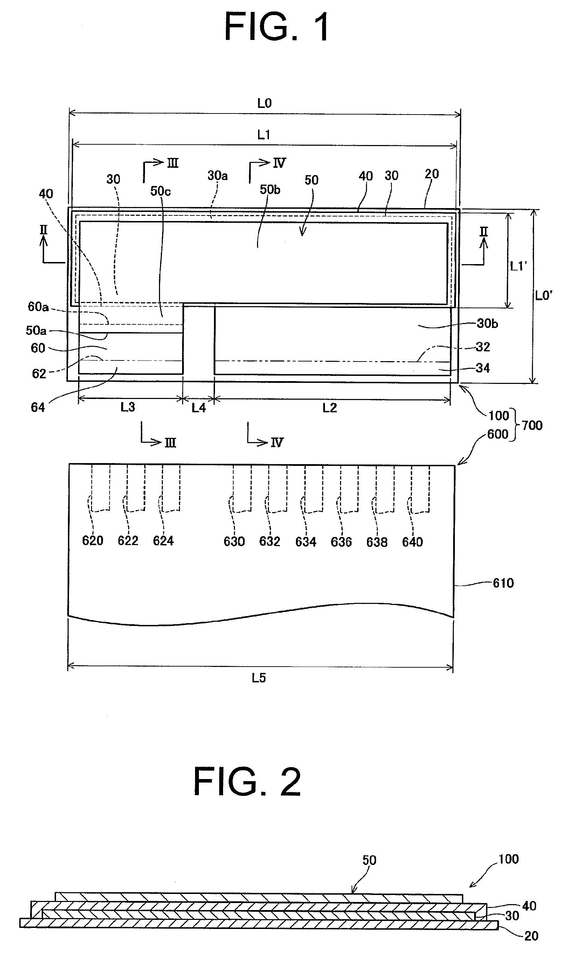

The following will describe a first preferred embodiment of an EL device unit 700 according to the present invention with reference to FIGs. 1 through 4.

Referring to FIG. 1, the EL device unit 700 includes an EL device 100 and a flexible printed circuit (FPC) 600. The EL device 100 includes a glass substrate 20, an anode 30, an EL layer 40 and a cathode 50. The glass substrate 20 is rectangular in plan view, having a uniform thickness, as shown in FIGs. 2 through 4. The glass substrate 20 is transparent and colorless, made of electrically insulating material.

The anode 30 is formed on the upper surface of the glass substrate 20. Note that in the preferred embodiment, the term "upper surface" means a near-side surface with respect to the direction of normal of the sheet of FIG. 1 and the term "lower surface" means a far-side surface with respect to the direction of normal of the sheet of FIG. 1. The other directions comply with directions as seeing drawings for description. The anode 30 is substantially L-shaped in plan view. Specifically, the anode 30 includes a portion 30a extending almost over the entire breadth of the glass substrate 20 and a portion 30b extending downward in FIG. 1 from the portion 30a mainly on the right side thereof. The anode 30 made of transparent and colorless indium tin oxide (ITO), having a uniform thickness, as shown in FIGs. 2 through 4. An anode terminal 34 is formed at the lower end of the portion 30b of the anode 30 for connection with terminals 630, 632, 634, 636, 638, 640 of the FPC 600, which will be described later. The anode terminal 34 is formed integrally with the other portion of the anode 30, made of the same material with the same thickness. Thus, the anode 30 is electrically connected to the anode terminal 34. The hypothetical line 32 in FIG. 1 indicates the upper end of the anode terminal 34. The FPC 600 will be connected onto the upper surface of the EL device 100 so that the upper end side of the FPC 600 overlaps the hypothetical line 32. The anode terminal 34 extends laterally, being formed along the lower long side of the EL layer 40, which will be described later. In other words, the anode terminal 34 is formed along the lower long side of the glass substrate 20.

The EL layer 40 is mainly formed on the upper surface of the anode 30. The EL layer 40 (For example, right and left end portions) is partially formed on the upper surface of the glass substrate 20, as best seen in FIGs. 2 through 4. The EL layer 40 is substantially rectangular in plan view, as shown in FIG. 1. As shown in FIGs. 2 through 4, a portion of the EL layer 40 formed on the upper surface of the anode 30 has a uniform thickness. The EL layer 40 uses a luminescent material such as Alq3 (organic electroluminescent material) to emit monochromatic light such as red, green and yellow or to emit luminescent color such as white light using a combination of red, green and yellow. White light may be obtained by bilaminar or trilaminar luminescent layers, a unilaminar luminescent layer containing different luminescent materials mixed with each other, or a unilaminar layer consisting of different luminescent layers defined therein. In addition, a functional layer such as a charge (hole or electron) injection layer, a charge transport layer and a blocking layer may be used in combination with the luminescent layer.

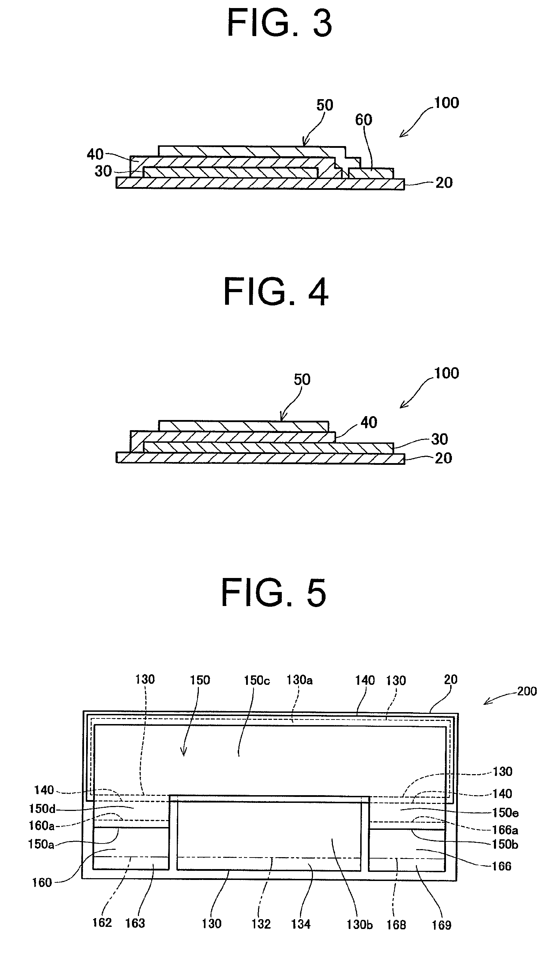

The cathode 50 made of metal is mainly formed on the upper surface of the EL layer 40, but the cathode 50 is partially formed on the upper surface of the glass substrate 20 and on the upper surface of a connection 60, as best shown in FIG. 3. The cathode 50 is substantially L-shaped in plan view, as shown in FIG. 1. Specifically, the cathode 50 has a portion 50b extending almost over the entire breadth of the EL layer 40 and a portion 50c extending downward in FIG. 1 from the portion 50b on the left side thereof. The reference symbol 50a indicates the lower end of the portion 50c of the cathode 50.

As shown in FIGs. 2 through 4, the cathode 50 formed on the upper surface of the EL layer 40 has a uniform thickness. The cathode 50 is made of metal, such as aluminum, gold, silver copper chromium and alloy of these metals, having a lower volume resistivity than ITO. As is clear from the above description, the anode 30 is connected to the lower surface of the EL layer 40, and the cathode 50 is connected to the upper surface of the EL layer 40. Thus, the EL layer 40 is sandwiched between the anode 30 and the cathode 50.

The connection 60 is formed on the glass substrate as shown in FIG. 3. The connection 60 is laterally long rectangular in plan view, as shown in FIG. 1. The cathode 50 is connected to the upper surface of the connection 60 at the upper portion thereof. Thus, the cathode 50 is electrically connected to the connection 60. The reference symbol 60a in FIG. 1 indicates the upper end of the connection 60. The connection 60 is made of ITO, which is the same material as the anode 30. The connection 60 has a cathode terminal 64 at the lower side thereof for connection with terminals 620 through 624 of the FPC 600, which will be described later. The cathode terminal 64 is called "cathode terminal" for differentiation from the other portion of the connection 60, but its structure is not different from that of the other portion of the connection 60. The cathode terminal 64 is made of the same material as the other portion of the connection 60 with the same thickness. Thus, the cathode 50 is electrically connected to the cathode terminal 64 through the connection 60. The hypothetical line 62 in FIG. 1 indicates the upper end of the cathode terminal 64. The FPC 600 will be connected onto the upper surface of the EL device 100 so that the upper end side of the FPC 600 overlaps the hypothetical line 62. The cathode terminal 64 is formed along the lower long side of the EL layer 40, that is, along the lower long side of the glass substrate 20. The cathode terminal 64 is aligned with the anode terminal 34 side by side with a gap L4 formed therebetween.

The size of the above-described EL device 100 will now be described.

The EL layer 40 has a breadth L1 of approximately 100 mm, which is larger than those of the anode 30 and the cathode 50. The clearance between the right side of the EL layer 40 and the right side of the glass substrate 20 is approximately 1 mm. The clearance between the left side of the EL layer 40 and the left side of the glass substrate 20 is approximately 1 mm. Thus, the glass substrate 20 has a breadth L0 of approximately 102 mm. The anode terminal 34 has a breadth L2 of approximately 97 mm. The cathode terminal 64 has a breadth L3 of approximately 2 mm. The gap L4 between the anode terminal 34 and the cathode terminal 64 is approximately 1 mm.

In the first preferred embodiment, the breadth L2 of the anode terminal 34 is much larger than breadth L3 of the cathode terminal 64. The anode 30 made of ITO has a higher volume resistivity than the cathode 50, so that the breadth L2 of the anode terminal 34 is formed larger. This makes a voltage to be applied uniformly in the long side direction of the anode 30. The narrow cathode terminal 64 is applicable for the cathode 50 due to the low volume resistivity of the cathode 50. Thus, when the material of the anode 30 has a higher volume resistivity than the cathode 50, the long side length of the EL layer 40 along (on or adjacent to) the anode terminal 34 is larger than that of the EL layer 40 along (on or adjacent to) the cathode terminal 64. The glass substrate 20 has a width L0' of approximately 6 mm. The EL layer 40 has a width L1' of approximately 2 mm. In the first preferred embodiment, the EL layer 40 has a very narrow width, formed in a substantially rectangular shape having a long side and a short side with a ratio of approximately 50 to 1. Therefore, the EL layer 40 is almost linear. The anode 30, the EL layer 40 and the cathode 50 each are extremely thin on the order of nanometer. The glass substrate 20 is thicker than these layers 30, 40, 50.

The FPC 600 will now be described.

The FPC 600 includes a substrate material 610, terminals (first conductors) 630, 632, 634, 636, 638, 640 for connection with the anode terminal 34 and terminals (second conductors) 620, 622, 624 for connection with the cathode terminal 64. The substrate material 610 is made of electrically insulating material. The illustration of the lower side of the FPC 600 is omitted in FIG. 1. The terminals 620, 622, 624 are formed on the lower surface of the substrate material 610. The terminal 620 is made of electrically conductive material extending vertically in FIG. 1. Similarly, the terminals 622 and 624 each are also made of electrically conductive material extending vertically. The terminals 620 through 624 are connected to an external power source (not shown) at their lower sides, respectively. Each of the terminals 620 through 624 is a thin and narrow wiring pattern.

The terminals 630, 632, 634, 636, 638, 640 are formed at the lower surface of the substrate material 610. The terminal 630 is made of electrically conductive material extending vertically in FIG. 1. Similarly, the terminals 632 through 640 each are also made of electrically conductive material extending vertically. The terminals 630 through 640 are connected to the external power source (not shown) at their lower sides, respectively. Each of the terminals 630 through 640 is a thin and narrow wiring pattern. The lower surface of the FPC 600 will be connected onto the upper surfaces of the cathode terminal 64 and the anode terminal 34. An anisotropic conductive film will be used for connection. Upon connection, the terminals 620 through 624 are to be in contact with the cathode terminal 64 and the terminals 630 through 640 are to be in contact with the anode terminal 34.

The EL device 100 and the FPC 600 are connected together to form the EL device unit 700. The breadth L5 of the FPC 600 is slightly smaller than the breadth L0 of the glass substrate 20 of the EL device 100. When the EL device 100 is connected to the FPC 600, the FPC 600 fits within the breadth of the glass substrate 20 of the EL device 100. The EL device unit 700 in which the FPC 600 fits within the breadth of the glass substrate 20 is very compact in its breadth direction. A high electric potential will be applied to the anode terminal 34 through the terminals 630 through 640 of the FPC 600. On the other hand, a low electric potential will be applied to the cathode terminal 64. Then, a potential difference arises between the anode 30 and the cathode 50. Thus, the EL layer 40 is supplied with electric power to emit light. Since the anode 30 and the glass substrate 20 are transparent and colorless, light emitted from the EL layer 40 directly transmits the anode 30 and the glass substrate 20 or transmits them after being reflected on the cathode 50. Emitted light exits from the lower surface of the glass substrate 20. The anode terminal 34 extends laterally, so that a potential difference is small in the lateral direction of the anode 30. The cathode terminal 64 has a smaller breadth than the anode terminal 34, but a potential difference is small in the lateral direction of the cathode 50 due to the low volume resistivity of metal forming the cathode 50. This causes a voltage applied to the EL layer 40 to be small in difference as measured in the lateral direction, with the result that electric current flowing through the EL layer 40 is small in difference as measured in the lateral direction. Thus, uneven brightness is reduced in the lateral direction.

As described above, according to the EL device 100 in the first preferred embodiment, uneven brightness is reduced at any positions of the EL layer 40. Furthermore, the anode terminal 34 and the cathode terminal 64 are all formed at the lower side in FIG. 1, so that the terminals 630 through 640 and the terminal 620 through 624 may be aligned along one side (the upper side in FIG. 1) of the substrate material 610 of the FPC 600. Thus, the structure of the FPC 600 will be simple.

The EL device unit 700 has a larger long side length of the EL layer 40 along the glass substrate 20 than the long side length of the EL layer 40 along the FPC 600. Thus, the EL device unit 700 including the FPC 600 is very compact. The EL device unit 700 according to the first preferred embodiment is applicable to a light source for optical readers, such as copiers, facsimiles and scanners. Since the FPC 600 does not extend in the long side direction of the EL device unit 700, an optical reader and a copier, a facsimile and a scanner using it will be compact, especially in the longitudinal direction of the EL device unit.

The following will describe a second preferred embodiment of an EL device 200 with reference to FIG. 5.

Referring to FIG. 5, the EL device 200 includes a glass substrate 20, an anode 130, an EL layer 140 and a cathode 150. The glass substrate 20 is the same as one in the first preferred embodiment, and the description is omitted. In addition, the anode 130, the EL layer 140 and the cathode 150 are made of the same material as those in the first preferred embodiment, and the description of the materials is omitted. In the following third and other preferred embodiments, the description of the glass substrate 20 and the description of the materials of components will be omitted. The anode 130 is formed on the upper surface of the glass substrate 20. The anode 130 is substantially T-shaped in plan view. Specifically, the anode 130 includes a portion 130a extending almost over the entire breadth of the glass substrate 20 and a portion 130b extending downward in FIG. 5 from the center of the portion 130a. An anode terminal 134 is formed at the lower end of the portion 130b of the anode 130 for connection with terminals (not shown) of the FPC. The hypothetical line 132 in FIG. 5 indicates the upper end of the anode terminal 134. The anode terminal 134 is formed along the lower long side of the EL layer 140. The EL layer 140 is mainly formed on the upper surface of the anode 130. The EL layer 140 is substantially rectangular in plan view.

The cathode 150 made of metal is mainly formed on the upper surface of the EL layer 140. The cathode 150 is substantially U-shaped in plan view. Specifically, the cathode 150 has a portion 150c extending almost over the entire breadth of the EL layer 140, a portion 150d extending downward in FIG. 5 from the portion 150c on the left side thereof and a portion 150e extending downward in FIG. 5 from the portion 150c on the right side thereof. The reference symbol 150a indicates the lower end of the portion 150d of the cathode 150. The reference symbol 150b indicates the lower end of the portion 150e of the cathode 150.

A first connection 160 is rectangular in plan view. The portion 150d of the cathode 150 is connected to the upper surface of the connection 160 on the upper side in FIG. 5. Thus, the cathode 150 is electrically connected to the first connection 160. The reference symbol 160a in FIG. 5 indicates the upper end of the first connection 160. A cathode terminal 163 is formed at the lower end of the first connection 160 for connection with terminals (not shown) of the FPC. The hypothetical line 162 in FIG. 5 indicates the upper end of the cathode terminal 163. The cathode terminal 163 extends laterally, being formed along the lower long side of the EL layer 140.

A second connection 166 is also rectangular in plan view. The second connection 166 has the same breadth as the first connection 160. The portion 150e of the cathode 150 is connected to the upper surface of the second connection 166 on the upper side in FIG. 5. Thus, the cathode 150 is electrically connected to the second connection 166. The reference symbol 166a in FIG. 5 indicates the upper end of the second connection 166. A cathode terminal 169 is formed at the lower end of the second connection 166 for connection with terminals (not shown) of the FPC. The hypothetical line 168 in FIG. 5 indicates the upper end of the cathode terminal 169. The cathode terminal 169 extends laterally, being formed along the lower long side of the EL layer 140. The breadth of the anode terminal 134 (lateral length) is larger than the sum of the breadths of the cathode terminals 163 and 169 and is half or larger than the breadth of the EL layer 140.

The FPC (not shown) has terminals for connection with the cathode terminals 163, 169 and terminals for connection with the anode terminal 134. When the FPC is connected to the EL device 200, the FPC will fit within the breadth of the glass substrate 20. The anode terminal 134 extends laterally, so that a potential difference is small in the lateral direction of the anode 130. The sum of the breadths of the cathode terminals 163, 169 is smaller than that of the anode terminal 134, but a potential difference is small in the lateral direction of the cathode 150 due to a low volume resistivity of metal forming the cathode 150. This causes a voltage applied to the EL layer 140 to be small in difference as measured in the lateral direction, with the result that electric current flowing through the EL layer 140 is small in difference as measured in the lateral direction. Thus, uneven brightness is reduced in the lateral direction.

As described above, according to the EL device 200 in the second preferred embodiment, uneven brightness is reduced at any positions of the EL layer 140. Furthermore, the anode terminal 134 and the cathode terminals 163, 169 are all formed at the lower side in FIG. 5, so that the terminals may be aligned along one side of the substrate material of the FPC. Thus, the structure of the FPC will be simple.

In the second preferred embodiment, the long side length of the EL layer 140 along the glass substrate 20 is larger than the long side length of the EL layer 140 along the FPC. Thus, the EL device unit including the FPC is very compact. The EL device unit according to the second preferred embodiment is applicable to a light source for optical readers, such as copiers, facsimiles and scanners. Since the FPC does not extend in the long side direction of the EL device unit, an optical reader and a copier, a facsimile and a scanner using it will be compact, especially in the longitudinal direction of the EL device unit.

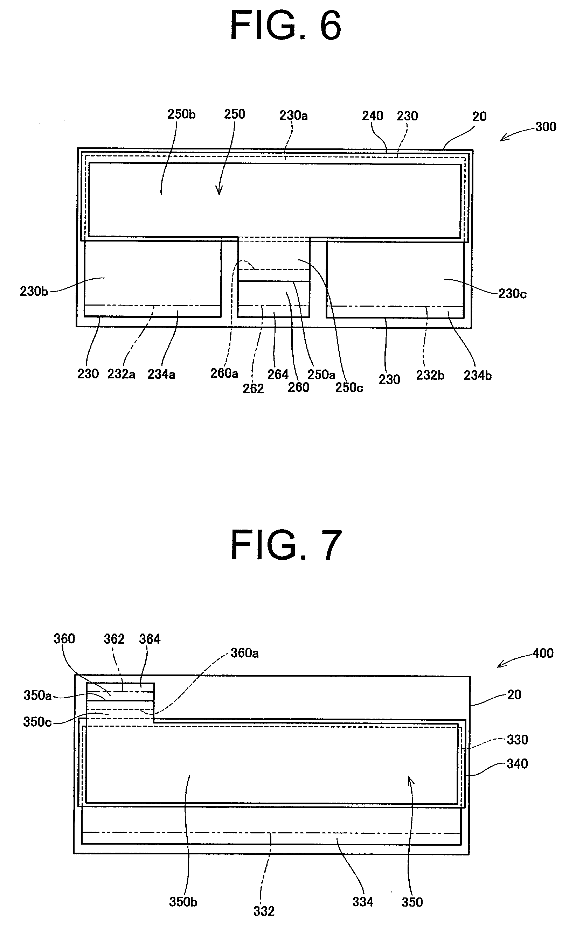

The following will describe a third preferred embodiment of an EL device 300 with reference to FIG. 6.

Referring to FIG. 6, the EL device 300 includes a glass substrate 20, an anode 230, an EL layer 240 and a cathode 250. The anode 230 is formed on the upper surface of the glass substrate 20. The anode 230 is substantially U-shaped in plan view. Specifically, the anode 230 has a portion 230a extending almost over the entire breadth of the glass substrate 20, a portion 230b extending downward in FIG. 6 from the portion 230a on the left side thereof and a portion 230c extending downward in FIG. 6 from the portion 203a on the right side thereof. An anode terminal 234a is formed at the lower end of the portion 230b of the anode 230 for connection with terminals (not shown) of the FPC. The hypothetical line 232a in FIG. 6 indicates the upper end of the anode terminal 234a. The anode terminal 234a extends laterally, being formed along the lower long side of the EL layer 240. On the other hand, an anode terminal 234b is formed at the lower end of the portion 230c of the anode 230 for connection with terminals (not shown) of the FPC. The hypothetical line 232b in FIG. 6 indicates the upper end of the anode terminal 234b. The anode terminal 234b extends laterally, being formed along the lower long side of the EL layer 240. The EL layer 240 is mainly formed on the upper surface of the anode 230 and substantially rectangular in plan view.

The cathode 250 made of metal is mainly formed on the upper surface of the EL layer 240. The cathode 250 is substantially T-shaped in plan view. Specifically, the cathode 250 has a portion 250b extending almost over the entire breadth of the EL layer 240 and a portion 250c extending downward in FIG. 6 from the center of the portion 250b. The reference symbol 250a indicates the lower end of the portion 250c. A connection 260 is rectangular in plan view. The portion 250c of the cathode 250 is connected to the upper surface of the connection 260 on the upper side in FIG. 6. Thus, the cathode 250 is electrically connected to the connection 260. The reference symbol 260a indicates the upper end of the connection 260. A cathode terminal 264 is formed at the lower end of the connection 260 for connection with terminals (not shown) of the FPC. The hypothetical line 262 in FIG. 6 indicates the upper end of the cathode terminal 264. The cathode terminal 264 extends laterally, being formed along the lower long side of the EL layer 240. The sum of the breadths of the anode terminals 234a and 234b (lateral length) is larger than the breadth of the cathode terminal 264 and is half or larger than the breadth of the EL layer 240.

The FPC (not shown) has terminals for connection with the cathode terminal 264 and terminals for connection with the anode terminals 234a, 234b. When the FPC is connected to the EL device 300, the FPC will fit within the breadth of the glass substrate 20. In the third preferred embodiment, the anode terminals 234a, 234b extend laterally, so that a potential difference is small in the lateral direction of the anode 230. The breadth of the cathode terminal 264 is smaller than that of the anode terminals 234a, 234b, but a potential difference is small in the lateral direction of the cathode 250 due to a low volume resistivity of metal forming the cathode 250. This causes a voltage applied to the EL layer 240 to be small in difference as measured in the lateral direction, with the result that electric current flowing through the EL layer 240 is small in difference as measured in the lateral direction. Thus, uneven brightness is reduced in the lateral direction.

As described above, according to the EL device 300 in this embodiment, uneven brightness is reduced at any positions of the EL layer 240. Furthermore, the anode terminals 234a, 234b and the cathode terminal 264 are all formed at the lower side in FIG. 6, so that the terminals may be aligned along one side of the substrate material of the FPC. Thus, the structure of the FPC will be simple.

In the third preferred embodiment, the long side length of the EL layer 240 along the glass substrate 20 is larger than the long side length of the EL layer 240 along the FPC. Thus, the EL device unit including the FPC is very compact. The EL device unit according to the third preferred embodiment is applicable to a light source for optical readers, such as copiers, facsimiles and scanners. Since the FPC does not extend in the long side direction of the EL device unit, an optical reader and a copier, a facsimile and a scanner using it will be compact, especially in the longitudinal direction of the EL device unit.

The following will describe a fourth preferred embodiment of an EL device 400 with reference to FIG. 7.

Referring to FIG. 7, the EL device 400 includes a glass substrate 20, an anode 330, an EL layer 340 and a cathode 350. The anode 330 is formed on the upper surface of the glass substrate 20 and rectangular in plan view. Specifically, the anode 330 extends almost over the entire breadth of the glass substrate 20. An anode terminal 334 is formed at the lower end of the anode 330 for connection with terminals (not shown) of the FPC. The hypothetical line 332 indicates the upper end of the anode terminal 334. The anode terminal 334 is formed along the lower long side of the EL layer 340. The EL layer 340 is mainly formed on the upper surface of the anode 330 and extends laterally. The EL layer 340 is rectangular in plan view.

The cathode 350 made of metal is mainly formed on the upper surface of the EL layer 340. The cathode 350 is substantially L-shaped in plan view. Specifically, the cathode 350 has a portion 350b extending almost over the entire breadth of the EL layer 340 and a portion 350c extending upward in FIG. 7 from the portion 350b on the left side thereof. The reference symbol 350a indicates the upper end of the portion 350c. A connection 360 is rectangular in plan view. The portion 350c of the cathode 350 is connected to the upper surface of the connection 360 on the lower side in FIG. 7. Thus, the cathode 350 is electrically connected to the connection 360. The reference symbol 360a indicates the lower end of the connection 360. A cathode terminal 364 is formed at the upper end of the connection 360 for connection with terminals (not shown) of the FPC. The hypothetical line 362 in FIG. 7 indicates the lower end of the cathode terminal 364. The cathode terminal 364 is formed along the upper long side of the EL layer 340. The breadth of the anode terminal 334 (lateral length) is larger than that of the cathode terminal 364 and slightly smaller than the breadth of the EL layer 340.

The FPC (not shown) has a first substrate (not shown) having terminals for connection with the cathode terminal 364 and a second substrate (not shown) having terminals for connection with the anode terminal 334. The first substrate and the second substrate may be integrated or separated. When the FPC is connected to the EL device 400, the FPC will fit within the breadth of the glass substrate 20.

In the fourth preferred embodiment, the anode terminals 334 extend laterally, so that a potential difference is small in the lateral direction of the anode 330. The breadth of the cathode terminal 364 is smaller than that of the anode terminal 334, but a potential difference is small in the lateral direction of the cathode 350 due to a low volume resistivity of metal forming the cathode 350. This causes a voltage applied to the EL layer 340 to be small in difference as measured in the lateral direction, with the result that electric current flowing through the EL layer 340 is small in difference as measured in the lateral direction. Thus, uneven brightness is reduced in the lateral direction.

As described above, according to the EL device 400 in this embodiment, uneven brightness is reduced at any positions of the EL layer 340. In the fourth preferred embodiment, the long side length of the EL layer 340 along the glass substrate 20 is larger than the long side length of the EL layer 340 along the FPC. Thus, the EL device unit including the FPC is very compact. The EL device unit according to the fourth preferred embodiment is applicable to a light source for optical readers, such as copiers, facsimiles and scanners. Since the FPC does not extend in the long side direction of the EL device unit, an optical reader and a copier, a facsimile and a scanner using it will be compact, especially in the longitudinal direction of the EL device unit.

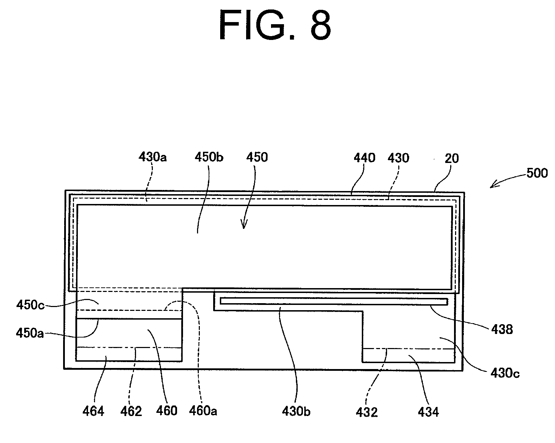

The following will describe a fifth preferred embodiment of an EL device 500 with reference to FIG. 8.

Referring to FIG. 8, the EL device 500 includes a glass substrate 20, an anode 430, an EL layer 440 and a cathode 450. The anode 430 is formed on the upper surface of the glass substrate 20. The anode 430 is substantially step-shaped in plan view. Specifically the anode 430 has a portion 430a extending almost over the entire breadth of the glass substrate 20, a portion 430b extending downward in FIG. 8 from the portion 430a mainly on the right side thereof and a portion 430c extending downward in FIG. 8 from the portion 430b on the right side thereof. An anode terminal 434 is formed at the lower end of the portion 430c for connection with terminals (not shown) of the FPC. The hypothetical line 432 indicates the upper end of the anode terminal 434. The anode terminal 434 is formed along the lower long side of the EL layer 440. The EL layer 440 is mainly formed on the upper surface of the anode 430 and substantially rectangular in plan view.

The cathode 450 made of metal is mainly formed on the upper surface of the EL layer 440. The cathode 450 is substantially L-shaped in plan view. Specifically, the cathode 450 has a portion 450b extending almost over the entire breadth of the EL layer 440 and a portion 450c extending downward in FIG. 8 from the portion 450b on the left side thereof. The reference symbol 450a indicates the lower end of the portion 450c. A connection 460 is rectangular in plan view. The portion 450c of the cathode 450 is connected to the upper surface of the connection 460 on the upper side in FIG. 8. Thus, the cathode 450 is electrically connected to the connection 460. The reference symbol 460a indicates the upper end of the connection 460. A cathode terminal 464 is formed at the lower end of the connection 460 for connection with terminals (not shown) of the FPC. The hypothetical line 462 indicates the upper end of the cathode terminal 464. The cathode terminal 464 extends laterally. The cathode terminal 464 is formed along the lower long side of the EL layer 440. The breadth of the anode terminal 434 (lateral length) is substantially equal to the breadth of the cathode terminal 464.

In the fifth preferred embodiment, the anode terminal 434 has a smaller breadth than the above described preferred embodiments. An auxiliary electrode 438 is provided for supplying power constantly over the anode 430 in the lateral direction. The auxiliary electrode 438 is formed on the upper surface of the portion 430b of the anode 430. The auxiliary electrode 438 extends laterally, having a larger breadth (lateral length) than the anode terminal 434. The auxiliary electrode 438 is made of the same material as the cathode 450, so that the auxiliary electrode 438 has a very low volume resistivity (much smaller than ITO).

The FPC (not shown) has terminals for connection with the cathode terminal 464 and terminals for connection with the anode terminal 434. When the FPC is connected to the EL device 500, the FPC will fit within the breadth of the glass substrate 20. In the fifth preferred embodiment, the anode terminal 434 has a small breadth but the auxiliary electrode 438 extends laterally, so that a potential difference is small in the lateral direction of the anode 430. The cathode terminal 464 has a smaller breadth than the portion 430b of the anode 430, but a potential difference is small in the lateral direction of the cathode 450 due to a low volume resistivity of metal forming the cathode 450. This causes a voltage applied to the EL layer 440 to be small in difference as measured in the lateral direction, with the result that electric current flowing through the EL layer 440 is small in difference as measured in the lateral direction. Thus, uneven brightness is reduced in the lateral direction.

As described above, according to the EL device 500 in the fifth preferred embodiment, uneven brightness is reduced at any positions of the EL layer 440. Furthermore, the anode terminal 434 and the cathode terminals 464 are all formed at the lower side in FIG. 8, so that the terminals may be aligned along one side of the substrate material of the FPC. Thus, the structure of the FPC will be simple.

In the fifth preferred embodiment, the long side length of the EL layer 440 along the glass substrate 20 is larger than the long side length of the EL layer 440 along the FPC. Thus, the EL device unit including the FPC is very compact. The EL device unit according to the second preferred embodiment is applicable to a light source for optical readers, such as copiers, facsimiles and scanners. Since the FPC does not extend in the longitudinal direction of the EL device unit, an optical reader and a copier, a facsimile and a scanner using it will be compact, especially in the longitudinal direction of the EL device unit. In the fifth preferred embodiment, the anode terminal 434 will be small, so that the number of terminals for the FPC may be smaller. Thus, the structure of the FPC will be simple.

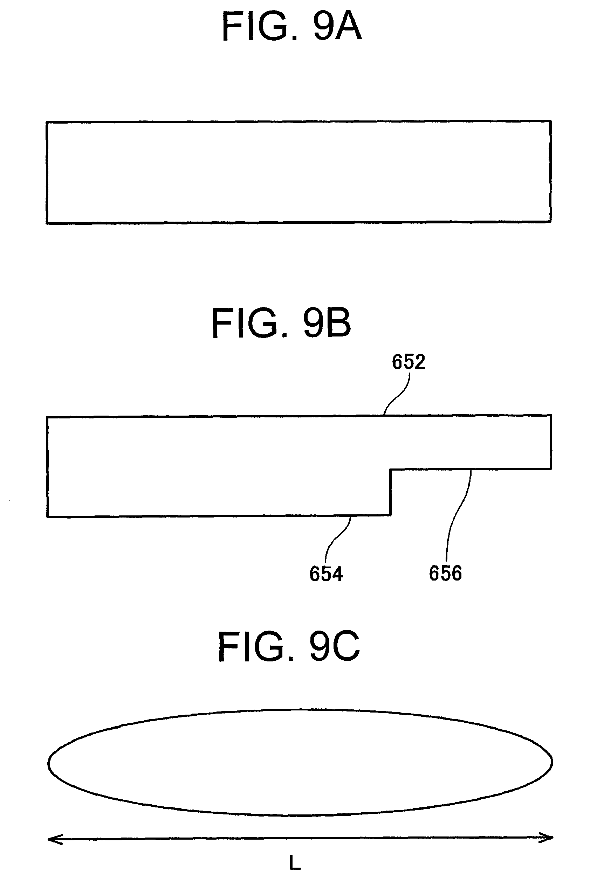

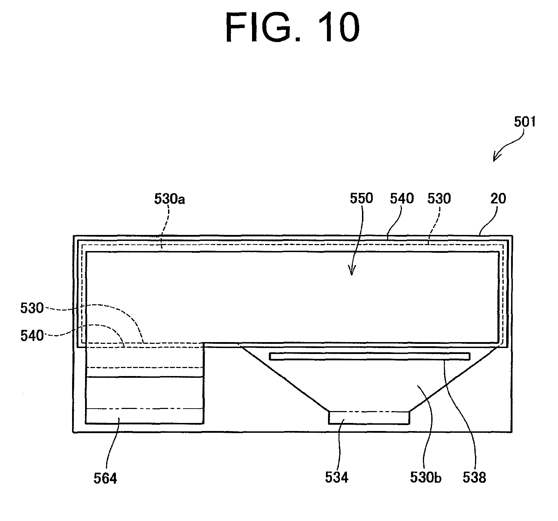

The present invention is not limited to the embodiments described above but may be modified into the following alternative embodiments.
(1) In the first preferred embodiment, the breadth L1 of the EL layer 40 is substantially equal to the sum of the breadth L2 of the anode terminal 34 and the breadth L3 of the cathode terminal 64. However, the breadth L2 or L3 may be smaller than the gap L4. The breadth L2, the breadth L3 and the gap L4 may be substantially equal. Alternatively, the breadth L2 is substantially equal to the breadth L3, and the sum of the breadths L2 and L3 is half or larger than the breadth L1.
   As far as the anode terminal (such as the anode terminal 34) and the cathode terminal (such as the cathode terminal 64) fit within the breadth L1 of the EL layer (such as the EL layer 40) on the glass substrate 20, they may be formed on any positions in the width L1' direction of the EL layer (the short side direction of the EL layer). Furthermore, as far as the anode terminal (such as the anode terminal 34) and the cathode terminal (such as the cathode terminal 64) are formed along the long side direction of the EL layer (such as the EL layer 40) within the breadth L1, the breadth L2 and the breadth L3 may be smaller than the breadth L1.
(2) In the above-preferred embodiments, three terminals 620 through 624 (as shown in FIG. 1) are used for connection with the cathode terminal and six terminals 630 through 640 are used for connection with the anode terminals. However, the number of these terminals may be changed. Furthermore, in the preferred embodiments, the wiring pattern formed on the substrate is used as terminals. However, the structure of the terminals may be changed when necessary.
(3) Shapes of various types may be employed for the EL layer. The rectangular shape as shown in FIG. 9A may be employed, while the shape as shown in FIG. 9B may also be employed. The shape shown in FIG. 9B is substantially rectangular. In this case, an anode terminal and a cathode terminal may be aligned along the long side 652.
   Alternatively, the side 654 and the side 656 may be regarded as one long side. One electrode terminal is formed along the side 654 and the other electrode terminal is formed along the side 656. An elliptical EL layer as shown in FIG. 9C may be used. In this case, the conductor substrate such as an FPC preferably fits within the breadth of the substrate for supporting the EL layer. It is also applicable that the conductor substrate fits within the breadth L of the EL layer.
(4) An anode having a shape as shown in FIG. 10 may be used. In the EL device 501, the reference numeral 530 indicates an anode, the reference numeral 540 indicates an EL layer and the reference numeral 550 indicates a cathode. The cathode 550 is made of metal. For example, the shape in which the breadth of the portion 530b of the anode 530 changes as seen in the long side direction of the EL layer 540 may be employed. In other words, as shown in FIG. 10, a trapezoid shape in which the breadth of the anode 530 gradually widens as it extends from the anode terminal 534 having substantially the same breadth as the cathode terminal 564 toward the portion 530a may be employed.

Furthermore, the auxiliary electrode 538 having a much smaller volume resistivity than ITO may be formed as shown in FIG. 10. The auxiliary electrode 538 is formed at a position on the portion 530b of the anode 530 and remote from the anode terminal 534 (a region in which a distance from the anode terminal 534 is longer than that from the EL layer 540), so that electric current flowing from the anode terminal 534 uniformly flows into the EL layer 540. Thus, a difference of electric current flowing into the EL layer 540 is reduced in the lateral direction, and uneven brightness is reduced in the lateral direction.

Therefore, the present examples and embodiments are to be considered as illustrative and not restrictive, and the invention is not to be limited to the details given herein but may be modified within the scope of the appended claims.

An electroluminescent device has an electroluminescent layer, a first electrode, a second electrode, a first terminal and a second terminal. The electroluminescent layer is substantially rectangular and has two long sides and two short sides in plan view. The first electrode is connected to a first surface of the electroluminescent layer. The second electrode connected to a second surface of the electroluminescent layer. The second surface is opposite the first surface. The first terminal is connected to the first electrode. The second terminal is connected to the second electrode. The first terminal is formed along one long side of the electroluminescent layer. The second terminal is formed along one long side or the other long side of the electroluminescent layer.

## Claims

1. An electroluminescent device comprising an electroluminescent layer that is substantially rectangular and that has two long sides and two short sides in plan view, a first electrode connected to a first surface of the electroluminescent layer, a second electrode connected to a second surface of the electroluminescent layer, wherein the second surface is opposite the first surface, a first terminal connected to the first electrode, and a second terminal connected to the second electrode, **characterized in that** the first terminal is formed along one long side of the electroluminescent layer, and **in that** the second terminal is formed along the same long side as the first terminal of the electroluminescent layer or the other long side thereof.

2. The electroluminescent device according to claim 1, wherein the first terminal and the second terminal are all formed along the same long side of the electroluminescent layer.

3. The electroluminescent device according to any one of claims 1 and 2, wherein the first electrode is made of material having a higher volume resistivity than that of the second electrode, and wherein a length of the first terminal along the long side of the electroluminescent layer is larger than that of the second terminal along the long side of the electroluminescent layer.

4. The electroluminescent device according to claim 3, wherein the length of the first terminal along the long side of the electroluminescent layer is equal to or larger than half of the electroluminescent layer.

5. The electroluminescent device according to any one of claims 1 through 4, **characterized in that** an auxiliary electrode made of material having a lower volume resistivity than that of the first electrode is formed on a surface or inside the first electrode, **in that** the auxiliary electrode is formed between the first terminal and an area of the first electrode to which the electroluminescent layer is connected and at a position in which a distance from the first terminal is longer than that from the electroluminescent layer, and **in that** the first electrode is made of material having a higher volume resistivity than that of the second electrode.

6. The electroluminescent device according to claim 5, wherein a length of the auxiliary electrode along the long side of the electroluminescent layer is larger than that of the first terminal along the long side of the electroluminescent layer.

7. The electroluminescent device according to any one of claims 1 through 6, wherein the electroluminescent layer contains an organic electroluminescent material.

8. The electroluminescent device according to any one of claims 1 through 7, wherein the electroluminescent layer is elliptical in plan view.

9. The electroluminescent device according to any one of claims 1 through 8, **characterized in that** the first electrode is formed on an upper surface of a transparent electroluminescent device substrate made of glass.

10. The electroluminescent device according to any one of claims 1 through 9, wherein the first electrode is substantially L-shaped in plan view and the second electrode is substantially L-shaped in plan view.

11. The electroluminescent device according to any one of claims 1 through 9, wherein the first electrode is substantially T-shaped in plan view and the second electrode is substantially U-shaped in plan view.

12. The electroluminescent device according to any one of claims 1 through 9, wherein the first electrode is substantially U-shaped in plan view and the second electrode is substantially T-shaped in plan view.

13. The electroluminescent device according to claim 1, wherein the first electrode is substantially rectangular in plan view and the second electrode is substantially L-shaped in plan view.

14. The electroluminescent device according to any one of claims 1 through 9, wherein the first electrode is substantially step-shaped in plan view and the second electrode is substantially L-shaped in plan view.

15. An electroluminescent device unit comprising the electroluminescent device of any one of claims 1 through 14, **characterized in that** a conductor substrate includes a first conductor connected to the first terminal and a second conductor connected to the second terminal, **in that** the electroluminescent device includes an electroluminescent device substrate, and **in that** a long side length of the electroluminescent layer along the electroluminescent device substrate is larger than that of the electroluminescent layer along the conductor substrate.

16. The electroluminescent device unit according to claim 15, wherein the conductor substrate is a flexible printed circuit.

17. The electroluminescent device unit according to any one of claims 15 and 16, wherein the first terminal and the second terminal are all formed along the same long side of the electroluminescent layer.

18. The electroluminescent device unit according to any one of claims 15 through 17, wherein the first conductor and the second conductor are all formed along one side of the conductor substrate.

19. An electroluminescent device unit comprising an electroluminescent device and a conductor substrate, wherein the electroluminescent device includes a laterally long electroluminescent layer in plan view, a first electrode connected to a first surface of the electroluminescent layer, a second electrode connected to a second surface of the electroluminescent layer, the second surface being opposite the first surface, and an electroluminescent device substrate, wherein the conductor substrate includes a first conductor electrically connected to the first electrode of the electroluminescent device, and a second conductor electrically connected to the second electrode of the electroluminescent device, **characterized in that** a breadth of the electroluminescent device substrate is larger than that of the conductor substrate.
